# EUROPEAN PATENT APPLICATION

(11) **EP 2 375 453 A2**
(43) Date of publication of application: **12.10.2011**
(21) Application number: 11161092.9
(22) Date of filing: 05.04.2011
(51) Int. Cl.: H01L 31/0392, H01L 31/072

(54) **Thin film solar cell and method for making the same**

(30) Priority: 08.04.2010 CN 201010147515
(71) Applicant: General Electric Company, Schenectady, NY 12345 (US)
(72) Inventor: Zhang, Minglong, Niskayuna, NY 12309 (US); Zhong, Dalong, Niskayuna, NY 12309 (US); Wu, Zhaoping, Niskayuna, NY 12309 (US)
(74) Representative: Szary, Anne Catherine

(57) **Abstract**

A thin film solar cell (1) comprises: a back contact layer (2); an absorber layer (3) adjacent to the back contact layer and comprising an absorber material and a dopant; a buffer layer (4); a dopant barrier layer (5) between the absorber layer and the buffer layer; and a window layer (6) adjacent to the buffer layer.

## Description

### BACKGROUND

The invention relates generally to thin film solar cells and methods for making the same. More particularly, this invention relates to thin film solar cells comprising dopants in absorber layers thereof.

Photovoltaic (PV) technology draws more and more attention in recent years because it utilizes sustainable, clean and renewable solar energy instead of traditional fossil fuel-based energy sources. Currently crystalline silicon solar cells are most popular commercialized photovoltaic devices, especially for terrestrial applications, because of their high performances. However, if photovoltaic electricity is to become a significant energy source, the production of solar cells has to increase substantially in volume and to decrease in cost. Thin film solar cells have basic advantages over the crystalline silicon solar cells concerning materials utilization, mass production and integrated module fabrication, which has been the driving force for their development since the early sixties in last century. As used herein, the term "thin film" is used to distinguish this type of solar cell from the crystalline silicon solar cells and may encompass a considerable thickness range, varying from a few nanometers to tens of micrometers. Cadmium telluride (CdTe), copper indium gallium diselenide (Cu(In/Ga)Se₂ or CIGS), and amorphous silicon (a-Si) are presently popular materials for thin film solar cells.

Energy conversion efficiency is an aspect of thin film solar cells still under development. For example, copper (Cu) is proposed to be doped into CdTe absorber layer of CdTe thin film solar cell to improve the energy conversion efficiency. However, it is found that while the energy conversion efficiency is significantly increased as Cu is doped, the degradation of photovoltaic parameters of Cu doped CdTe thin film solar cell proceeds at a larger rate than those of CdTe solar cells without Cu, which is obviously undesirable. Studies suggest that contamination of a buffer layer (e.g., cadmium sulfide (CdS) layer) adjacent to the absorber layer (CdTe layer) and a junction between the buffer layer (CdS layer) and the absorber layer (CdTe layer) by the dopants (Cu) from the absorber layer (CdTe layer) is one of the causes of acceleration of the degradation of the CdTe thin film solar cells. Other kinds of thin film solar cells may have similar problems in doping the absorber layers thereof. However, no effective solution has been found to decelerate the accelerated degradation.

Therefore, there is a need to develop a new thin film solar cell and a method for making the new thin film solar cell.

### BRIEF DESCRIPTION

In one aspect, the invention relates to a thin film solar cell comprising: a back contact layer, an absorber layer adjacent to the back contact layer and comprising an absorber material and a dopant, a buffer layer, a dopant barrier layer between the absorber layer and the buffer layer, and a window layer adjacent to the buffer layer.

In another aspect, the invention relates to a method for making a thin film solar cell, comprising: providing a back contact layer, providing an absorber layer adjacent to the back contact layer and comprising an absorber material and a dopant, providing a buffer layer; providing a dopant barrier layer between the absorber layer and the buffer layer, and providing a window layer adjacent to the buffer layer.

In yet another aspect, the invention relates to a thin film solar cell comprising: a back contact layer, an absorber layer adjacent to the back contact layer and comprising cadmium telluride and copper, a buffer layer comprising cadmium sulfide, a copper barrier layer between the absorber layer and the buffer layer, and a window layer adjacent to the buffer layer.

### DRAWINGS

These and other features, aspects, and advantages of the present invention will become better understood when the following detailed description is read with reference to the accompanying drawings in which like characters represent like parts throughout the drawings, wherein:
FIG. 1 is a schematic cross-sectional view of a thin film solar cell in accordance with a first embodiment of the present invention; and
FIG. 2 is a schematic cross-sectional view of a thin film solar cell in accordance with a second embodiment of the present invention.

### DETAILED DESCRIPTION

Preferred embodiments of the present disclosure will be described hereinbelow with reference to the accompanying drawings. In the following description, well-known functions or constructions are not described in detail to avoid obscuring the disclosure in unnecessary detail.

Approximating language, as used herein throughout the specification and claims, may be applied to modify any quantitative representation that could permissibly vary without resulting in a change in the basic function to which it is related. Accordingly, a value modified by a term or terms, such as "about" or "substantially", is not to be limited to the precise value specified. In some instances, the approximating language may correspond to the precision of an instrument for measuring the value.

Any numerical values recited herein include all values from the lower value to the upper value in increments of one unit provided that there is a separation of at least 2 units between any lower value and any higher value. As an example, if it is stated that the amount of a component or a value of a process variable such as, for example, temperature, pressure, time and the like is, for example, from 1 to 90, preferably from 20 to 80, more preferably from 30 to 70, it is intended that values such as 15 to 85, 22 to 68, 43 to 51, 30 to 32 etc. are expressly enumerated in this specification. These are only examples of what is specifically intended and all possible combinations of numerical values between the lowest value and the highest value enumerated are to be considered to be expressly stated in this application in a similar manner.

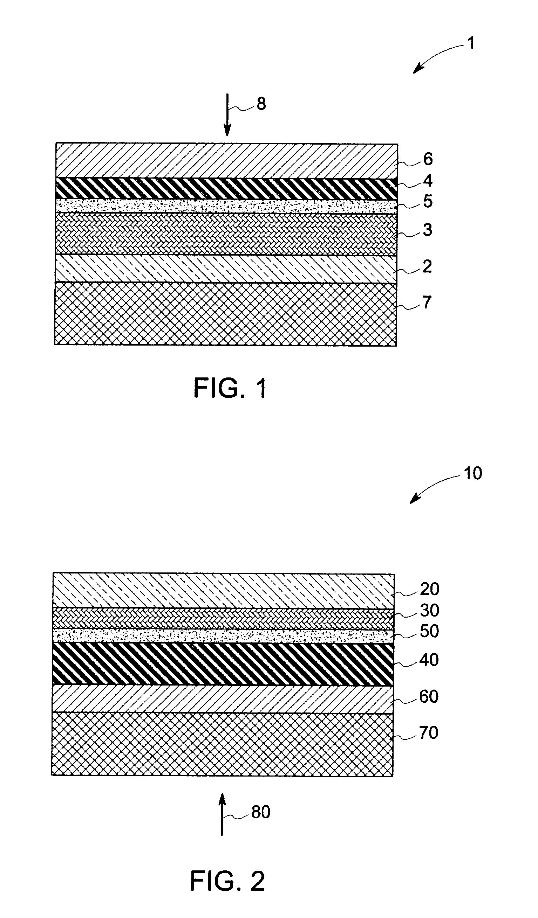

FIG. 1 is a schematic cross-sectional view of a thin film solar cell 1 in accordance with a first embodiment of the present invention. The thin film solar cell 1 comprises: a back contact layer 2, an absorber layer 3 adjacent to the back contact layer 2 and comprising an absorber material (not shown) and a dopant (not shown), a buffer layer 4, a dopant barrier layer 5 between the absorber layer 3 and the buffer layer 4, and a window layer 6 adjacent to the buffer layer 4.

The absorber material may be any PV absorbing material suitable for thin film solar cells and able to be doped. Examples of the absorber material include but are not limited to cadmium telluride (CdTe), copper indium gallium diselenide (Cu(In/Ga)Se₂ or CIGS), copper indium aluminum diselenide (Cu(In/Al)Se₂) and any of these compounds with sulfur replacing some of the selenium, amorphous silicon (a-Si), microcrystalline silicon (µc-Si), Si:Ge and Si:C alloys, thin film silicon, copper oxide (CuO or Cu₂O or CuₓO_{y}), sodium titanate, potassium niobate, cadmium selenide (CdSe), cadmium suflide (CdS), copper sulfide (Cu₂S), cadmium-tellurium selenide (CdTeSe), copper-indium selenide (CuInSe₂), cadmium oxide (CdOₓ), CuI, a semiconductive material, various kinds of nanostructured photoelectrochemical and organic materials, or combinations of the above.

The dopant may be any doping material that is suitable for doping into the absorber layer of the thin film solar cell. In some embodiment, the absorber material comprises cadmium tellurium and the dopant comprises copper.

The layers of the thin film solar cell 1 may be individual layers on their own and may also be combined or integrated with each other as long as it will not change the basic function of the thin film solar cell.

Both the buffer layer 4 and the window layer 6 are transparent for transmitting light to be absorbed in the absorber layer 3. In some embodiments, the buffer layer 4 and the window layer 6 are integral with each other, for example, the buffer layer 4 and the window layer 6 may comprise only one material, such as cadmium sulfide (CdS). In other embodiments, the buffer layer 4 and window layer 6 are separate from each other. For example, the buffer layer 4 may comprise cadmium sulfide while the window layer 6 comprises transparent conductive oxides. Examples of transparent conductive oxides include but are not limited to indium tin oxide (ITO) possibly doped with fluorine (F) or antimony (Sb), tin oxide (SnO₂ or SnOₓ) possibly doped with F or Sb, zinc oxide (ZnO) possibly doped with boron (B) or aluminium (Al), and cadmium stannate (Cd₂SnO₄, sometimes also written as CdSnO₃).

The dopant barrier layer 5 is transparent. The dopant barrier layer 5 may be so thin as to minimize the impact on junctions between the absorber layer 3 and the buffer layer 4 and at the same time be thick enough to prevent dopants in the absorber layer 3 from moving out and into the buffer layer 4. In such a way, contamination of the buffer layer 4 and a junction between the buffer layer 4 and the absorber layer 3 by the dopant from the absorber layer 3 is effectively controlled and accelerated degradation of the thin film solar cell 1 is eliminated/reduced. The dopant barrier layer 5 also reduces the effect of recombination at the absorber/buffer interface and/or improves the electric field within the junction. In some embodiments, a thickness of the dopant barrier layer 5 is in a range of from about 1 nm to about 100 nm or from about 5 nm to about 50 nm.

The dopant barrier layer 5 may comprise a doped or undoped nitride or a doped or undoped oxynitride. In some embodiments, the dopant is copper and the dopant barrier layer 5 may comprise at least one material selected from tantalum nitride (TaN), titanium nitride (TiN), hafnium nitride (HfN), zirconium nitride (ZrN), tungsten nitride (WN), molybdenum nitride (MoN), nickel nitride (NiN), ruthenium nitride (RuN), praseodymium nitride (PrN), titanium tungsten nitride (TiWN), tantalum silicon nitride (TaSiN), titanium silicon nitride (TiSiN), hafnium silicon nitride (HfSiN), zirconium silicon nitride (ZrSiN), tungsten silicon nitride (WSiN), molybdenum silicon nitride (MoSiN), nickel silicon nitride (NiSiN), ruthenium silicon nitride (RuSiN), praseodymium silicon nitride (PrSiN), tantalum oxynitride (TaNO), titanium oxynitride (TiNO), hafnium oxynitride (HfNO), zirconium oxynitride (ZrNO), tungsten oxynitride (WNO), molybdenum oxynitride (MoNO), nickel oxynitride (NiNO), ruthenium oxynitride (RuNO), and praseodymium oxynitride (PrNO).

The back contact layer 2 may be any conductive material making good contact with the absorber layer 3. Materials suitable for the back contact layer 2 may be selected from molybdenum (Mo), niobium (Nb), tantalum (Ta), copper (Cu), nickel (Ni), graphite, aluminum (Al), gold (Au) etc.

In some embodiments, the thin film solar cell 1 may further comprise a support layer 7. The support layer 7 may be made of glass (e.g., borosilicate glass, soda-lime glass), transparent plastic (e.g., polyimide) foil or metal foil.

In some embodiments, the support layer, the window layer and the buffer layer may be soda-lime glass, ITO/SnO₂, and CdS, respectively. In other embodiments, the support layer, the window layer and the buffer layer may be borosilicate glass, Cd₂SnO₄/Zn₂SnO₄ and CdS, respectively.

FIG. 2 is a schematic cross-sectional view of a thin film solar cell 10 in accordance with a second embodiment of the present invention. The thin film solar cell 10 is similar to the thin film solar cell 1 except that the thin film solar cell 1 is a substrate type in which the support layer 7 is located adjacent to the back contact layer 2 and light is transmitted in a direction 8. However, the thin film solar cell 10 is a superstrate type in which the support layer 70 is located adjacent to the window layer 60 and light is transmitted in a direction 80.

In another aspect, the present invention relates to a method for making a thin film solar cell 1, 10, comprising: providing a back contact layer 2, 20, providing an absorber layer 3, 30 adjacent to the back contact layer 2, 20 and comprising an absorber material and a dopant; providing a buffer layer 4, 40, providing a dopant barrier layer 5, 50 between the absorber layer 3, 30 and the buffer layer 4, 40; and providing a window layer 6, 60 adjacent to the buffer layer 4, 40.

In some embodiments, the thin film solar cell 1, 10 comprises other layers besides those mentioned above. For example, there may be a high resistance transparent layer (not shown) disposed between the window layer 6, 60 and the buffer layer 4, 40 and comprising tin oxide, indium oxide or cadmium oxide, etc. In some instances, there may be additional layers between the window layer 60 and the support layer 70. Deposition methods for layers of the thin film solar cells 1, 10 may be any suitable vacuum or nonvacuum techniques. Examples of vacuum techniques include but are not limited to sublimation technique (e.g., close spaced sublimation (CSS), close spaced vapour transport (CVT or CSVT)), evaporation techniques (e.g. thermal evaporation, electron-beam evaporation), stacked elemental layers (SEL) technique, atomic layer deposition (ALD), metal organic chemical vapor deposition (MOCVD), and Sputtering. Examples of nonvacuum techniques include but are not limited to electrodeposition, chemical bath deposition (CBD), solution spray, screen printing and sintering.

While only certain features of the invention have been illustrated and described herein, many modifications and changes will occur to those skilled in the art. It is, therefore, to be understood that the appended claims are intended to cover all such modifications and changes as fall within the true scope of the invention.

## Claims

1. A thin film solar cell (1, 10) comprising:
a back contact layer (2, 20);
an absorber layer (3, 30) adjacent to the back contact layer and comprising an absorber material and a dopant;
a buffer layer (4, 40);
a dopant barrier layer (5, 50) between the absorber layer and the buffer layer; and
a window layer (6, 60) adjacent to the buffer layer.

2. The thin film solar cell of claim 1, further comprising a support layer (7, 70).

3. The thin film solar cell of claim 1 or claim 2, wherein the dopant barrier layer has a thickness in a range of from about 1 nm to about 100 nm.

4. The thin film solar cell of any preceding claim, wherein the dopant barrier layer has a thickness in a range of from about 5 nm to about 50 nm.

5. The thin film solar cell of any preceding claim, wherein the dopant barrier layer comprises a doped or undoped nitride or a doped or undoped oxynitride.

6. The thin film solar cell of any preceding claim, wherein the dopant barrier layer is transparent.

7. The thin film solar cell of any preceding claim, wherein the absorber material comprises cadmium tellurium, the dopant comprises copper, the buffer layer comprises cadmium sulfide and the window layer comprises transparent conductive oxides.

8. The thin film solar cell of any preceding claim, wherein the dopant barrier layer comprises at least one material selected from tantalum nitride (TaN), titanium nitride (TiN), hafnium nitride (HfN), zirconium nitride (ZrN), tungsten nitride (WN), molybdenum nitride (MoN), nickel nitride (NiN), ruthenium nitride (RuN), praseodymium nitride (PrN), titanium tungsten nitride (TiWN), tantalum silicon nitride (TaSiN), titanium silicon nitride (TiSiN), hafnium silicon nitride (HfSiN), zirconium silicon nitride (ZrSiN), tungsten silicon nitride (WSiN), molybdenum silicon nitride (MoSiN), nickel silicon nitride (NiSiN), ruthenium silicon nitride (RuSiN), praseodymium silicon nitride (PrSiN), tantalum oxynitride (TaNO), titanium oxynitride (TiNO), hafnium oxynitride (HfNO), zirconium oxynitride (ZrNO), tungsten oxynitride (WNO), molybdenum oxynitride (MoNO), nickel oxynitride (NiNO), ruthenium oxynitride (RuNO), and praseodymium oxynitride (PrNO).

9. A method for making a thin film solar cell, comprising:
providing a back contact layer (2, 20);
providing an absorber layer (3, 30) adjacent to the back contact layer and comprising an absorber material and a dopant;
providing a buffer layer (4, 40);
providing a dopant barrier layer (5, 50) between the absorber layer and the buffer layer; and
providing a window layer (6, 60) adjacent to the buffer layer.

10. The method of claim 9, wherein the copper barrier layer comprises a doped or undoped nitride or a doped or undoped oxynitride.
